# EUROPÄISCHE PATENTSCHRIFT

(11) **EP 2 413 155 B1**
(45) Veröffentlichungstag und Bekanntmachung des Hinweises auf die Patenterteilung: **13.03.2013**
(21) Anmeldenummer: 11175518.7
(22) Anmeldetag: 27.07.2011
(51) Int. Cl.: G01R 33/3415, G01R 33/36, G01R 33/34

(54) **Modulare MRI Phased Array Antenne**
Modular MRI phased array antenna
Antenne à réseau phasé modulaire pour IRM

(30) Priorität: 30.07.2010 DE 102010038722
(43) Veröffentlichungstag der Anmeldung: 01.02.2012
(73) Patentinhaber: Bruker BioSpin AG, 8117 Fällanden (CH)
(72) Erfinder: Schmidig, Daniel, 8200 Schaffhausen (CH)
(74) Vertreter: Kohler Schmid Möbus

(56) Entgegenhaltungen:
- EP-A1- 1 521 094
- WO-A2-2008/073512
- DE-A1- 10 244 172
- US-A1- 2007 257 670
- US-A1- 2008 238 424

## Beschreibung

Die Erfindung betrifft eine Antennenanordnung zur Verwendung in einem Magnetresonanzgerät, die als phasengesteuertes Array aufgebaut ist und einen Trägerkörper aus einem stabilen Material und mindestens zwei Einzelantennen umfasst, welche jeweils mindestens eine Leiterschleife, ein Tuning-Netzwerk und ein Matching-Netzwerk aufweisen, wobei das Tuning-Netzwerk mindestens eine Tuning-Kapazität und das Matching-Netzwerk mindestens eine Matching-Kapazität enthält, und die Einzelantennen jeweils in separaten Modulen zusammengefasst sind, die auf dem Trägerkörper positioniert, befestigt und zerstörungsfrei von dort wieder entfernt werden können.

Eine solche Antennenanordnung ist aus der US 6,084,411 bekannt geworden.

### Vorgeschichte

Die Erfindung bezieht sich auf eine Abbildungsvorrichtung zur Nutzung der magnetischen Kernresonanz (NMR oder MR) unter Verwendung von Antennen (Spulen), die dem Senden und/oder Empfangen von Frequenzsignalen (Larmor-Frequenz) dienen und die in Arrays (Feldern) zusammengefasst sind, wobei die einzelne Antenne aus einer Leiterbahn besteht, die eine Fläche definiert.

Die Nutzung der magnetischen Kernresonanz hat als ein wichtiges bildgebendes Verfahren weite Verbreitung gefunden. Hierbei wird der Effekt genutzt, dass Kernspins in einem homogenen magnetischen Feld (B0) bei Zuführung von Energie vermittels elektromagnetischer Wellen bestimmter Frequenzen, aufgrund von Absorption eine Anregung erfahren. Die Frequenz bestimmt sich dabei aus der Stärke des konstanten Magnetfeldes (B0) und den speziellen charakteristischen Eigenschaften des Kernes. Nach kurzer Zeit kehren die angeregten Spins in ihren Grundzustand, also einen tieferen Energiezustand zurück und emittieren ein elektromagnetisches hochfrequentes Signal, dass über Empfangsantennen erfasst und zur Konstruktion eines Bildes genutzt werden kann. Grundsätzlich können die gleichen Antennenelemente zur Anregung (Senden) eines Signals als auch zum Empfang genutzt werden. Es ist möglich mehrere Antennen in so genannten Arrays zusammenzufassen. Je größer die Dichte, also die Anzahl der einzelnen Antennen pro Flächeneinheit, umso besser wird das Signal-/Rausch- Verhältnis (SNR). Damit kann zum Beispiel die Auflösung des hergeleiteten Bildes erhöht werden. Ein weiterer wichtiger Vorzug von Antennenarrays ist die Möglichkeit der Nutzung parallelbildgebender Verfahren sie z.B. SENSE oder GRAPPA. Mit diesen Verfahren lässt sich eine höhere Aufnahmegeschwindigkeit realisieren.

### Stand der Technik

Die vorliegende Erfindung betrifft ein Antennenarray bestehend aus mehreren Einzelantennen.

Bei der medizinischen Bildgebung mittels NMR werden hochfrequente Magnetfelder im MHz-Bereich aus dem menschlichen oder tierischen Körper mit einer HF-Antenne empfangen und zur Bildgebung weiter verarbeitet.

Im Vergleich zum Empfang mit einer Ganzkörperantenne wird mit einer Empfangsantenne welche als Oberflächenantenne (Lokalantennen oder Lokalspulen) ausgebildet ist, welche der Oberfläche des Objektes und dem zu untersuchenden Gebiet angepasst ist, ein höheres Signal zu Rausch Verhältnis (SNR) im MR-Bild erzielt.

Eine kleinere Oberflächenantenne bringt dabei ein höheres SNR als eine größere Oberflächenantenne, hat aber auch ein dementsprechend kleineres Field-of-View (FOV, abgebildeter Bereich). Wenn nun ein größeres FOV untersucht werden soll, wird aus diesem Grund anstelle einer einzelnen großen Antenne häufig mit einer Vielzahl von kleineren Antennen bzw. mit einem Array von kleineren Antennen gearbeitet. Dabei benötigt jede einzelne Empfangsantenne ihren eigenen Empfangspfad bestehend aus Vorverstärker, Kabel und Empfänger. Vorrichtungen dieser Arte werden als Phased-Array-Antennen oder Antennenarrays bezeichnet.

Die Einzelantennen sind dabei im Allgemeinen auf einer Fläche angeordnet, die der Geometrie des Untersuchungsgebietes angepasst ist.

Ein Problem bei Antennenarrays ist die Tatsache, dass mit mehreren nebeneinander angeordneten Einzelantennen ein Hochfrequenzstrom in einer der Einzelantennen eine Spannung in benachbarten Einzelantennen induzieren kann. Dies wird als Verkopplung (Kopplung) von Antennen untereinander bezeichnet wird. Verkopplungen treten sowohl bei Anordnungen von zirkular polarisierten Antennen als auch bei Anordnungen von linear polarisierten Einzelantennen auf. Verkopplungen verschlechtern das Signal-Rauschverhältnis (SNR) und erzeugt Artefakte im MR-Bild. Zudem ist der Aufwand für die Prüfung von verkoppelten Einzelantennen größer als für die Prüfung von nicht verkoppelten Einzelantennen. Ein Ziel beim Design von Phased-Array-Antennen ist deshalb, eine Verkopplung der Einzelantennen möglichst zu vermeiden.

### Entkopplungstechniken

Ein Antennenarray der eingangs genannten Art ist in der US 4,825,162 [1] beschrieben. Das Antennenarray umfasst mehrere nebeneinander angeordnete Einzelantennen. Zur Entkopplung überlappen sich benachbarte Einzelantennen zum Teil. Die Überlappung reduziert die Gegeninduktivität der benachbarten Einzelantennen. Anderseits erforderte die Überlappung eine überkreuzende Führung der Antennenleiter mit entsprechenden Kreuzungspunkten. Die Antennenleiter müssen an den Kreuzungspunkten voneinander isoliert geführte sein. Zudem treten bei höheren Frequenzen durch die an den Kreuzungspunkten gebildeten Kapazitäten wiederum kapazitive Kopplungen auf.

In der vorstehend bereits zitierten US 4,825,162 [1] ist eine weitere Maßnahme angegeben, Kopplungen zu vermindern. Sie besteht darin, die Impedanz eines an die Einzelantenne angeschlossenen Vorverstärkers so zu wählen, dass eine für die Einzelantenne an ihren Anschlüssen wirksame Impedanz, die auch vom Eingangswiderstand des Vorverstärkers bestimmt ist, möglichst groß ist. Damit verschwindet der in den Einzelantennen induzierte Strom nahezu, wodurch die in benachbarten Einzelantennen induzierte Spannung entsprechen niedrig und vernachlässigbar wird. Damit lässt sich allerdings nur mit einem hohen Aufwand eine ausreichende Entkopplung erreichen. Diese Art der Entkopplung wird daher in der Praxis zusammen mit anderen Entkopplungstechniken eingesetzt. Diese Art der Entkopplung wird im Folgenden als Vorverstärkerentkopplung bezeichnet.

Ein weiteres Antennenarray ist in der US 5,216,368 [3] beschrieben. Das Antennenarray umfasst zwei senkrecht zueinander ausgerichtete Antennensysteme. Bei exakter Ausrichtung sind die beiden Antennensysteme allein durch ihre Anordnung voneinander entkoppelt. Unsymmetrien verursachen jedoch Verkopplungen der beiden Antennensysteme, die durch einen Kondensator, der die beiden Antennensysteme verbindet, kompensiert wird.

In der DE 41 13 120 C2 [4] ist ein Antennensystem mit einer Mantelwellensperre beschrieben. Die Mantelwellensperre unterdrückt unerwünschte Hochfrequenz- Einkopplung über die Leitungen der Antenne.

In der DE 10 2004 046 188 A1 [5] ist ein Antennenarray für ein Magnetresonanzgerät mit einer kapazitiven Kompensation der induktiven Verkopplung beschrieben. Benachbarte Einzelantennen weisen jeweils eine Unterbrechung auf. An den Unterbrechungen sind die Einzelantenne elektrisch parallel geschaltet sind. Mindestens eine der Unterbrechungen ist mit einem kapazitiven Element überbrückt, wobei das kapazitive Element einen Kapazitätswert aufweist, bei dem die Einzelantennen voneinander entkoppelt sind. Die Einzelantennen sind über die Entkopplungsschaltung allerdings galvanisch verbunden, wodurch eine Gleichtakt-Signalverbindung entsteht.

In der DE 102 44 172 A1 [6] wird ein weiteres Entkopplungselement bestehend aus einer galvanischkontaktfreien Entkopplungsantenne beschrieben. Diese Entkopplungsantenne ist so ausgebildet und/oder angeordnet, dass sie mit den benachbarten Einzelantennen induktiv derart koppelt, dass die induktive Kopplung zwischen den beiden betreffenden Einzelantennen minimal ist. Häufig wird bei Antennen dieser Art aus diesem Grund komplett auf den Einsatz von Entkopplungselementen verzichtet und die Einzelantennen werden lediglich über die oben beschriebene Vorverstärkerentkopplung voneinander entkoppelt.

### Konforme Antennen

Um die Einzelantennen auf einer Fläche anzuordnen, welch der Geometrie des Untersuchungsgebietes möglichst gut angepasst ist, werden mit Vorteil flexible Antennen eingesetzt.

So beschreibt US 6,650,926 B1 [7] zum Beispiel eine Phased-Array-Antennenanordnung bestehend aus mehreren starren Antennenelementen, welche über ein Scharnier miteinander verbunden sind und so an die Patientengeometrie angepasst werden kann.

US 2008/0238424 A1 [8] dagegen beschreibt eine Phased-Array-Antennenanordnung wo die ganze HF-Antenne auf einem flexiblen Substrat aufgebracht ist und dadurch als Ganzes flexibel ist

Eine andere Möglichkeit eine Phased-Array-Antenne der Geometrie des abzubildenden Objektes anzupassen ist es, die Phased-Array-Antenne modular aufzubauen, sodass die Einzelantennen der Phased-Array-Antenne entsprechend der gewünschten Geometrie angeordnet werden können. Ein Antennensystem dieser Art ist in US 6,084,411 [9] beschrieben.

Alle diesen Lösungsansätzen ist jedoch ein Problem gemeinsam. Durch Verformen eines Antennenarrays bzw. durch umplatzieren von einzelnen Antennen eines Antennenarrays ändert sich die gegenseitige Kopplung der Einzelantennen, was dazu führt dass die Entkopplungselemente nachgeregelt werden müssen um die Kopplung der Einzelantennen wieder zu minimieren.

### Die erfindungsgemäßen Vorrichtung

Ziel der erfindungsgemäßen Vorrichtung ist es, Einzelantennenmodule zu definieren, die auf einfache Weise um das Messvolumen herum angeordnet werden können und zugleich untereinander elektromagnetisch entkoppelt sind, und die vorzugsweise dicht am Messvolumen positioniert werden können, damit das empfangene MRI-Bild ein möglichst hohes Signal-zu-Rauschverhältnis besitzt.

Erreicht wird dieses Ziel dadurch, dass die Einzelantennen durch Entkopplungselemente miteinander verbunden sind, und dass die Entkopplungselemente am Trägerkörper befestigt sind und von diesem nicht entfernt werden können.

Es ist also wünschenswert, dass
1. die Phased-Array-Antenne in irgendeiner Form flexibel ist, damit alle Einzelantennen des Arrays möglichst nahe am Objekt positioniert werden können und die Phased-Array-Antenne so möglichst gut auf eine Vielzahl von verschiedenen Objektgrößen und -formen passt.
2. die unter Punkt 1 beschriebene Flexibilität derart erreicht wird, dass die Einzelelemente der Phased-Array-Antenne nicht verformt werden müssen.
3. die Entkopplung der Einzelantennen trotz der unter Punkt 1 beschriebenen Flexibilität gewährleistet ist.

*In der vorliegenden Erfindung werden die oben aufgelisteten Ziele dadurch erreicht,* dass man sich einer Antennenanordnung, die zu einem Magnetresonanzgerät gehört und als phasengesteuertes Array aufgebaut ist, bedient, wie sie in Anspruch 1 definiert wird.. Durch Bereitstellen unterschiedlicher Trägerkörper kann die passende Geometrie in modularer Weise zusammengebaut werden.

### Detaillierte Beschreibung der Erfindung

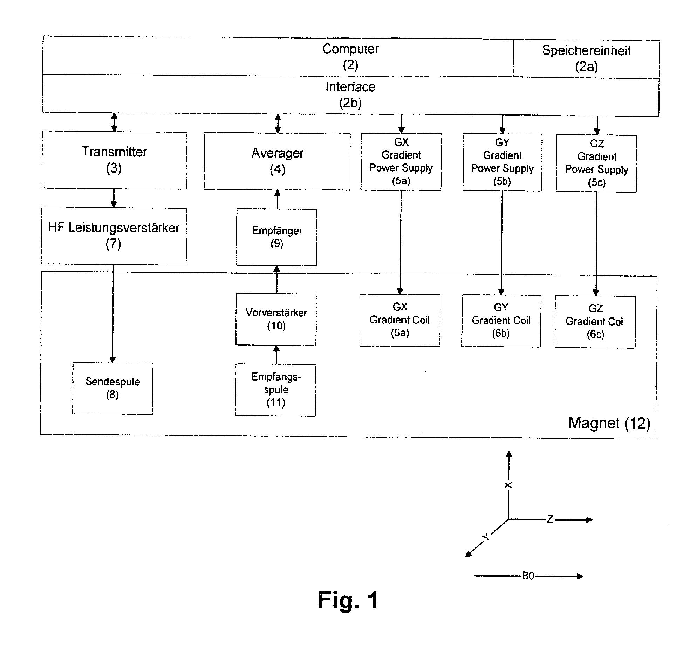

Fig. 1 ist ein vereinfachtes Blockdiagramm der wesentlichen Komponenten eines Magnet Resonanz Imaging (MRI) - Systems, welches für den Gebrauch mit einer in dieser Erfindung beschriebenen Antennenanordnung geeignet wäre.

Das System besteht aus einem Computer, welcher mit einer Speichereinheit und einer Schnittstelleneinheit verbunden ist.

Ein Hochfrequenz (HF) Transmitter, ein HF - Empfänger und Stromversorgungen für die Gradienten, sind über die Schnittstelleneinheit mit dem Computer verbunden.

Die Stromversorgung der Gradienten versorgt die die Gradientenspulen, welche die Magnetfelder Gx, Gy und Gz mit einem Gradienten in X, Y und Z-Richtung über dem abzubildenden Objekt erzeugen.

Der HF - Transmitter wird über Pulse vom Computer getriggert und erzeugt so die HF-Pulse entsprechender Modulierung um ein MR-Signal im Objekt anzuregen.

Die HF-Pulse werden in einem HF - Leistungsverstärker auf Leistungen zwischen einigen hundert Watt bis mehreren Kilowatt, abhängig von der Bildgebungsmethode, verstärkt und auf die Sendeantenne gegeben.
Höhere Leistungen werden für größere Samplevolumen benötigt, wie z.B. bei der Erzeugung von Ganzkörper MR-Bildern und dort, wo kurze Pulse benötigt werden um große NMR Frequenzbandbreiten anzuregen.

Die von der Sendeantenne abgestrahlten HF-Pulse induzieren ein MR-Signal im Objekt, welches untersucht werden soll.

Das MR - Signal wird von einer Empfangsantenne empfangen, in einem rauscharmen Vorverstärker verstärkt und zum Empfänger weitergeleitet, wo das Signal weiter prozessiert (z.B. weiter verstärkt, gefiltert, gemischt, gemittelt usw.) wird.

In einer alternativen Anordnung existieren mehrere Empfangsantennen jede der Empfangsantennen ist dabei über ein Verbindungskabel mit einem eigenen rauscharmen Vorverstärker verbunden, welcher wiederum an einen eigenen Empfänger verbunden ist.

Das Signal wird dann digitalisiert und über die Schnittstelleneinheit an den Computer weitergeleitet, wo das Signal weiter prozessiert wird.

Vorverstärker und Empfänger werden durch aktives Wegschalten oder passive Filter von den hohen HF-Sendepulsen geschützt.

In einigen MR - Systemen wird zum Senden und Empfangen der HF - Signale dieselbe Antenne verwendet. Alternativ kann zum Senden und Empfangen des HF - Signals jeweils eine separate Antenne verwendet werden. In beiden Fällen ist das von den Antennen erzeugte magnetische Feld B1 orthogonal zum statischen Magnetfeld B0.

Die Gradientenspulen erzeugen Magnetfeldgradienten Gx Gy und Gz welche monoton und möglichst linear über dem Samplevolumen sind. Nicht monotone Gradientenfelder über dem Samplevolumen erzeugen Artefakte im MR - Bild, welche als ,Aliasing' bekannt sind. Nichtlineare Gradienten erzeugen geometrische Verzerrungen des MR-Bildes.

In der klinischen Anwendung werden MRI-Systeme benutzt um Bilder von verschiedenen Körperregionen von Individuen unterschiedlichster Größe zu erzeugen. Aus diesem Grund werden unterschiedlichster Empfangsantennen benötigt, welche dementsprechend auch häufig gewechselt werden müssen. Das Wechseln der Empfangsantennen ist zeitraubend und die Anschaffung separater Empfangsantennen für jede Anwendung ist sehr teuer.

Die vorliegende Erfindung beschreibt nun ein Antennensystem bestehend aus mehreren Einzelantennen, welche in modularer Weise zusammengesetzt werden können und so eine Phased-Array-Antenne bilden.

Im Folgenden ist nun die erfindungsgemäße Antennenanordnung, die zu einem Magnetresonanzgerät gehört und als phasengesteuertes Array aufgebaut ist, beschrieben. Die Antennenanordnung umfasst dabei mindestens zwei Einzelantennen, wobei die Einzelantennen durch Entkopplungselementen miteinander verbunden sind, wobei nur die Entkopplungselemente fix an einem Trägerkörper befestigt sind, und die Einzelantennen jeweils in separaten Modulen zusammengefasst sind, die am Trägerkörper positioniert, befestigt, und zerstörungsfrei von dort wieder entfernt werden können.

Durch Bereitstellen unterschiedlicher Trägerkörper kann damit die zum abzubildenden Objekt passende Geometrie in modularer Weise zusammengebaut werden.

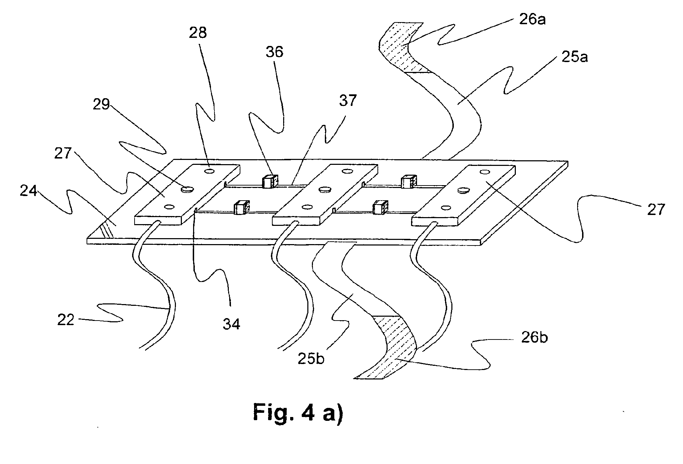

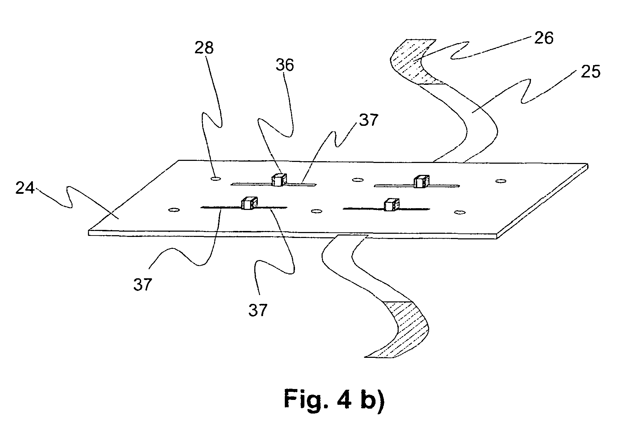

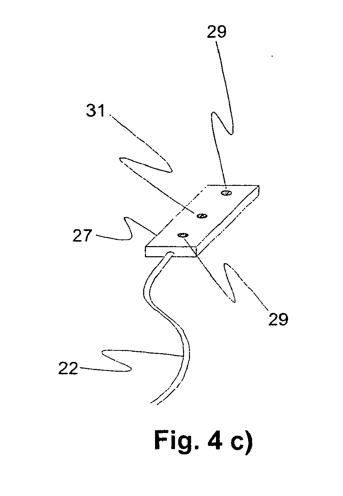

Fig. 4 a) stellt besagtes Antennensystem wie es der vorliegenden Erfindung entspricht dar, wenn die Einzelantennen auf dem Trägerkörper befestigt sind. Fig. 4 b) stellt einen Trägerkörper ohne Einzelantennenmodule dar. Und Fig. 4c) stellt ein Einzelantennenmodul dar.

### Das Einzelantennenmodul

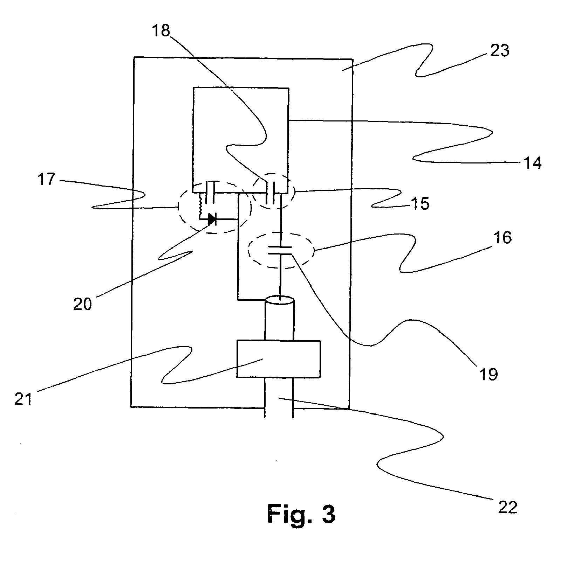

Eine schematische Darstellung eines Einzelantennenmodules ist in Fig. 3 gegeben. Die Einzelantenne besteht zumindest aus einer Leiterschleife, einem Tuning-Netzwerk, einem Matching-Netzwerk sowie vorzugsweise einem Detuning-Netzwerk, wobei das Tuning-Netzwerk mindestens eine Tuningkapazität, das Matching-Netzwerk mindestens eine Matching-Kapazität und das Detuning-Netzwerk vorzugsweise mindestens eine Diode enthält. Die Einzelantenne selber befindet sich in einem starren Gehäuse. Das Gehäuse ist so ausgebildet, dass es auf dem weiter unten beschriebenen Trägerkörper positioniert und befestigt werden kann. Im konkreten hier beschriebenen Fall umfasst dies zwei Bohrungen für die Aufnahme von Positionierstiften des Trägerkörpers und ein Loch durch welches das Einzelantennenmodul mit einer Rändelschraube auf dem Trägerkörper befestigt werden kann. Andere Möglichkeiten der Positionierung und Befestigung der Einzelantennenmodule auf dem Trägerkörper sind jedoch auch denkbar.

### Der Trägerkörper

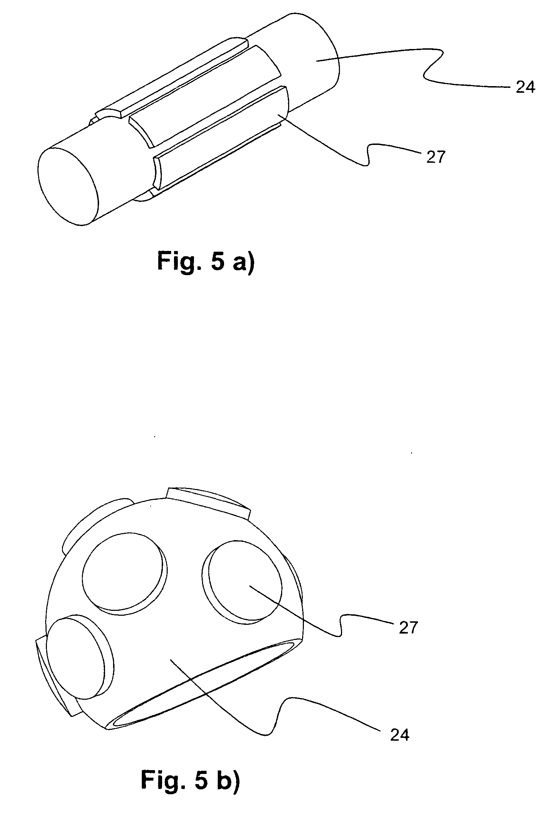

Der Trägerkörper, dargestellt in Fig. 4 b), definiert die Geometrie der Antennenanordnung. Der Trägerkörper ist aus MR-kompatiblem, stabilem Material (z.B. Glasfaserverstärktes Epoxidharz) gefertigt ist. In Fig. 4 b) hat der Trägerköper eine planare Geometrie. Die Geometrie des Trägerkörpers sei jedoch nicht darauf beschränkt, sondern kann vielmehr eine beliebige auf die Geometrie des abzubildenden Objektes angepasste Geometrie aufweisen. In Fig. 5 a) & b) sind weitere mögliche Geometrien für Trägerkörper dargestellt. Fig. 5 a) stellt einen zylindrischen Trägerkörper dar, wie er zum Beispiel für eine Antennenkonfiguration, wie sie zum Erzeugen von Ganzkörper MRI-Bildern oder MRI-Bildern von Extremitäten verwendet werden würde.

Fig. 5 b) stellt einen annähernd kugelförmigen Trägerkörper einem Ausschnitt dar, wie er zum Erzeugen von Kopf MRI-Bildern verwendet werden würde.

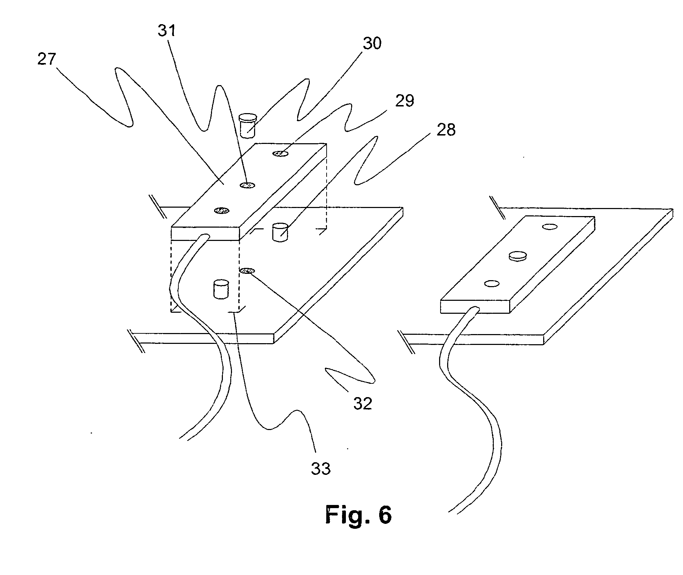

Zweckmäßigerweise sind am Trägerkörper auch Vorrichtungen zur Befestigung des Trägerkörpers am abzubildenden Objekt, wie (elastische) Bänder, Klettverschlüsse, Schnappverschlüsse oder ähnliches angebracht. In jedem Fall befinden sich auf dem Trägerkörper jedoch mehrere Vorrichtungen, welche zur Befestigung und Positionierung der Einzelantennen auf dem Trägerkörper dienen. In Fig. 6 ist eine einfache Ausführung einer solchen Vorrichtung zur Befestigung und Positionierung einer Einzelantenne auf dem Trägerkörper dargestellt, bestehend aus zwei Stiften im Trägerkörper, welche in zwei Bohrungen im Einzelantennenmodul passen und dieses so gegenüber dem Trägerkörper positioniert und einer Rändelschraube, mit welcher das Einzelantennenmodul auf dem Trägerkörper fixiert werden kann. Durch Lösen der Rändelschraube kann das Einzelantennenmodul einfach wieder vom Trägerkörper gelöst und gegebenenfalls auf einem anderen Trägerkörper befestigt werden.

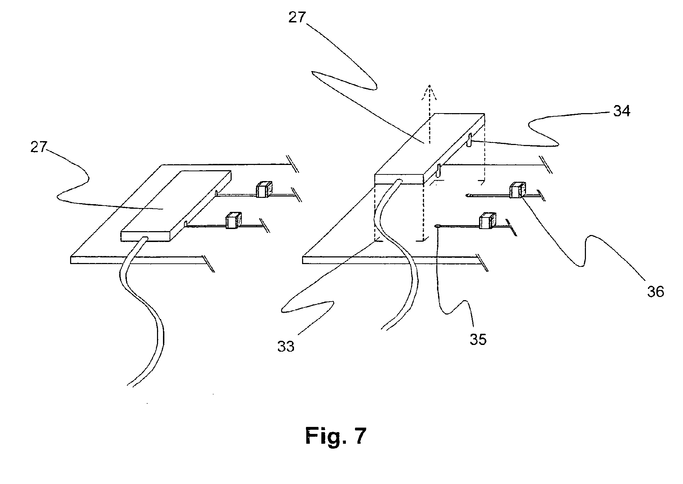

In jedem Fall befinden sich auf dem Trägerkörper auch Entkopplungselemente, welche zur Minimierung der Kopplung zwischen den Einzelantennenmodulen dienen. In der konkreten Ausführung, welche in Fig. 4 dargestellt ist, bestehen besagte Entkopplungselemente aus Kontakthülsen, kurzen Leiterbahnen und Kapazitäten. Dies ist in Fig. 7 noch etwas detaillierter dargestellt. Am Einzelantennenmodul befinden sich elektrische Kontaktstifte, welche beim Befestigen des Einzelantennenmodules auf dem Trägerkörper in die entsprechenden Kontakthülsen auf dem Trägerkörper eingeführt werden. Dadurch entsteht eine elektrische Verbindung zwischen dem Einzelantennenmodul und den Leiterbahnen auf dem Trägerkörper. Damit werden die Einzelantennenmodule in vorteilhafter Weise untereinander elektrisch verbunden. 'In Vorteilhafter Weise' heißt dabei, dass die Kopplung der benachbarten Einzelantennenmodule auf diese Weise minimiert wird.

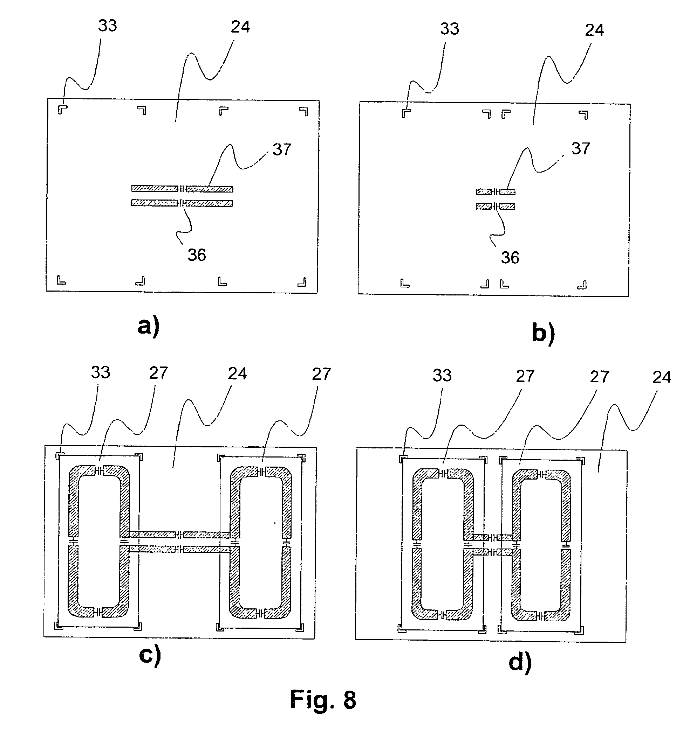

In Fig. 8 ist die Verwendung unterschiedlicher Trägerkörper und die Idee der zum Trägerkörper gehörenden Entkopplungselemente noch einmal etwas schematischer dargestellt.

Fig. 8 a) und Fig. 8 b) stellen dabei zwei unterschiedliche Trägerköper da. Der Trägerkörper dargestellt in Fig. 8 b) sieht dabei einen geringeren Abstand der Einzelantennenmodule vor als der Trägerkörper dargestellt in Fig. 8 a). Die Kopplung zweier näher zusammen liegender Antennen ist größer, weshalb die Entkopplungskapazitäten welche auf dem Trägerkörper in Fig. 8 b) einen höheren Kapazitätswert aufweisen werden als die Entkopplungskapazitäten auf Trägerkörper in Fig. 8 a).Fig. 8 c) und d) stellen nun die jeweiligen Trägerkörper aus Fig. 8 a) und b) mit montierten Einzelantennenmodulen dar.

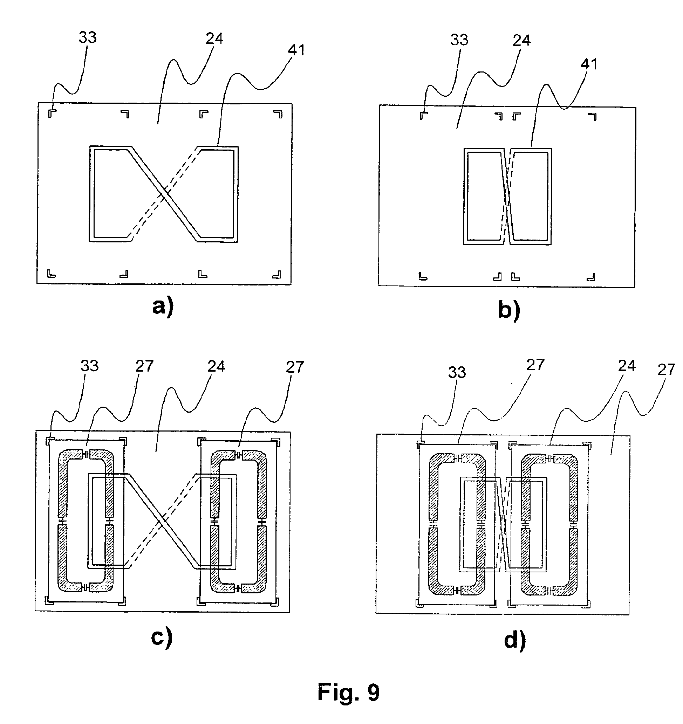

Fig. 9 a) und b) stellen eine weitere mögliche Ausführung der Erfindung dar. Fig. 9 a) und Fig. 9 b) stellen dabei zwei unterschiedliche Trägerköper da. Der Trägerkörper dargestellt in Fig. 9 b) sieht dabei einen geringeren Abstand der Einzelantennenmodule vor als der Trägerkörper dargestellt in Fig. 9 a).

Die Entkopplungselemente auf den Trägerkörpern bestehen hier nun lediglich aus einer geschlossenen Leiterbahn in Schmetterlingsform und müssen nicht elektrisch mit den Einzelantennenmodulen kontaktiert werden. Vorteil dieser Ausführung der Entkopplungselemente ist die Tatsache, dass kein galvanischer Kontakt zwischen Einzelantennenmodul und Entkopplungselement nötig ist. Die Idee eine Leiterschleife in Schmetterlingsform als Entkopplungselement zu verwenden ist dabei nicht neu, und wird unter anderem ausführlich in DE102 44 172 A1 beschrieben. Auch hier gilt, dass die Kopplung zweier näher zusammen liegender Antennen größer ist. Um die Kopplung der beiden Einzelantennen zu kompensieren, wird aus diesem Grund die Schmetterlingsantenne in Fig. 9 d) das Einzelantennenmodul etwas stärker überlappen als die Schmetterlingsantenne in Fig. 9 c).

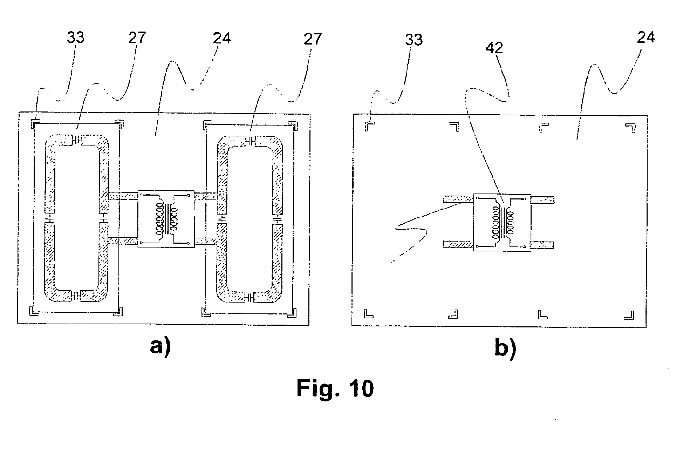

Fig. 10 a) und b) stellen eine weitere mögliche Ausführung der Erfindung dar. Wobei in diesem Fall das Entkopplungselement als Transformator ausgebildet ist. Fig. 10 a) stellt dabei den Trägerkörper mit dem darauf befestigten Transformator dar. In Fig. 10 b) sind zwei auf dem Trägerkörper befestigte Einzelantennenmodule dargestellt, welche mit den Anschlüssen des Transformators kontaktiert und damit entkoppelt sind.

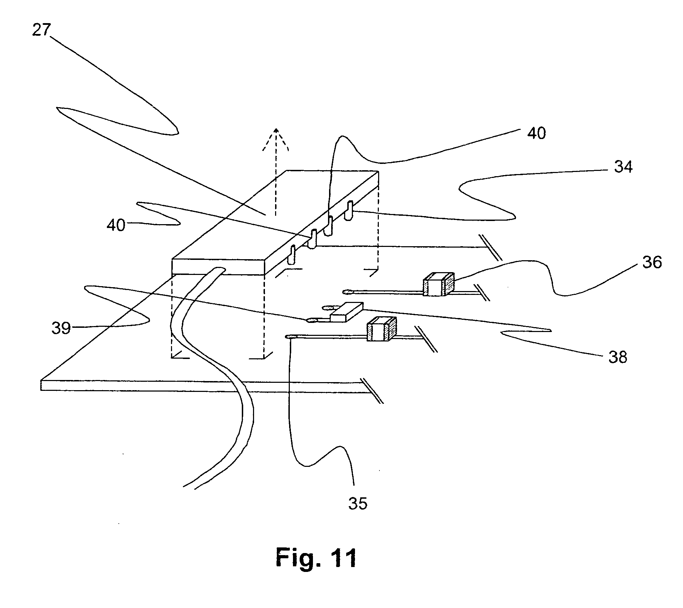

In einer etwas komplizierteren Ausführung der hier vorliegenden Erfindung ist auf dem Trägerkörper neben den oben beschriebenen Elementen für jedes Einzelantennenmodul zusätzlich noch ein Codierelement vorhanden. Im konkreten in Fig. 11 dargestellten Fall besteht dieses Codierelement aus einem Widerstand. Die Größe des Widerstandes ist je nach Position auf dem Trägerkörper und je nach Trägerkörpergeometrie unterschiedlich. D.h. der Widerstandswert codiert Trägerkörpergeometrie und Einzelantennen-Position auf dem Trägerkörper. Weiter existiert eine elektrische Verbindung zwischen den beiden Anschlüssen des Codierwiderstandes und dem Computer. Weiter sind ein oder mehrere kapazitive Elemente der Einzelantennenmodule (insbesondere z.B. die Matching-Kapazitäten) als Kapazitätsdioden realisiert.

D.h. die Kapazität dieser Elemente kann durch Änderung der über dem Element angelegten Spannung eingestellt werden. Weiter existiert eine elektrische Verbindung zwischen den beiden Anschlüssen jeder Kapazitätsdiode und je einer vom Computer gesteuerten Spannungsquelle. Diese Vorrichtung erlaubt es mit dem im Folgenden beschriebenen Verfahren bestimmte Kapazitätswerte der verschiedenen Einzelantennenmodule abhängig von der Trägerkörpergeometrie und der Position des Einzelantennenmodules auf dem Trägerkörper einzustellen.

Ein Verfahren, wie mit oben beschriebener Vorrichtung die Kapazitätsdioden in den Einzelantennenmodulen eingestellt werden kann:
Jedes Codierelement auf dem Trägerkörper wird über die jeweilige elektrische Verbindung vom Computer ausgelesen und mit einer zuvor erzeugten Liste von Widerstandswerten verglichen. Diese Liste ordnet in eindeutiger Weise jedem Widerstandswert einen Spannungswert zu. Der Computer steuert nun die entsprechenden Spannungsquellen so, dass über den jeweiligen Kapazitätsdioden die entsprechenden Spannungen anliegen, wodurch die Kapazitätsdioden einen bestimmten Kapazitätswert annehmen.

Die in der Liste eingetragenen Spannungswerte wurden vorgängig und einmalig so bestimmt, dass Veränderungen in der Anpassung der einzelnen Schwingkreise, welche sich durch die unterschiedliche Anordnung der Einzelantennenmodule ergeben, korrigiert werden.

Im Folgenden sein nun ein ***konkretes Beispiel*** der oben beschriebenen Erfindung gegeben.

Aufgabe sei die MRI-Untersuchung von Abdomen von Mäusen.

Dazu kann eine Phased-Array-Antenne mit 6 Einzelelementen verwendet werden, welche auf einer Zylindermantel-Oberfläche angeordnet sind. Dies ist in Fig. 5) a) schematisch dargestellt.

Um nun Spulen zu haben, welche auf unterschiedlich große Mäuse passen werden im Sinne der vorliegenden Erfindung 6 separate Einzelantennenmodule und ein Set von beispielsweise 3 Trägerkörpern unterschiedlicher Größe zur Verfügung gestellt.

Aus dem Set von Trägerkörpern kann nun der Zylinder ausgewählt werden, in welchen die zu untersuchende Maus noch knapp hineinpasst. Auf diesem Trägerkörper werden anschließend die 6 Antennenmodule befestigt werden. Damit hat man die gewünschte 6-fach Phased-Array-Antenne in der optimalen Größe für die gewünschte Untersuchung.

Die auf dem Trägerkörper befestigten Entkopplungselemente sorgen dabei dafür, dass die Einzelantennen möglichst gut entkoppelt sind.

In der nachfolgenden Liste sind alle vorhandenen Abbildungen beschrieben:
- Fig.1: Blockdiagramm MRI-System

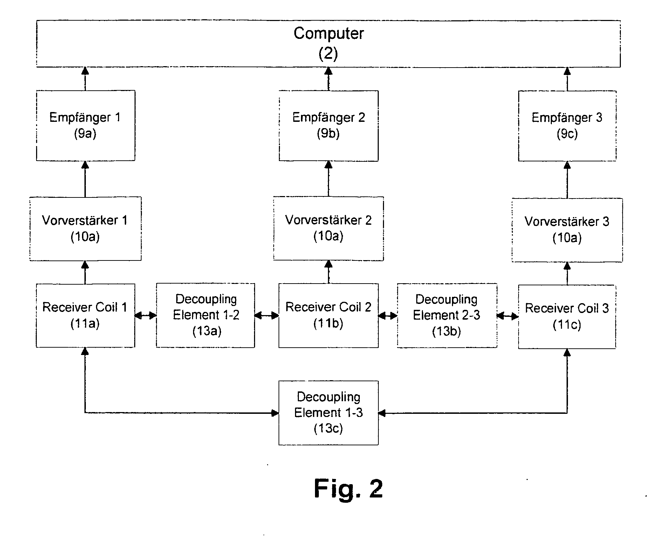

- Fig.2: Blockdiagramm Phased-Array-Antenne
- Fig.3: Schematische Darstellung eines Einzelantennenmoduls
- Fig.4a: Modulare MRI Phased-Array-Antenne
- Fig.4b: Trägerköper einer modularen Phased-Array-Antenne
- Fig.4c: Einzelantennen einer modularen Phased-Array-Antenne
- Fig.5: Verschiedene Geometrien von Trägerkörpern
- Fig.6: Vorrichtung zur Befestigung von Einzelantennen auf dem Trägerkörper
- Fig.7: Entkopplungskapazitäten als Entkopplungselemente
- Fig.8: Erfindungsgemäße Antennenanordnung mit Kapazitäten als Entkopplungselemente
- Fig.9: Erfindungsgemäße Antennenanordnung mit Schmetterlingsantennen als Entkopplungselemente
- Fig.10: Erfindungsgemäße Antennenanordnung mit Transformatoren als Entkopplungselemente
- Fig.11: Trägerkörper mit Codierelement

### Referenzliste

- [1]:: US 4,825,162
- [2]:: DE 38 20 168 A1
- [3]:: US 5,216,368
- [4]:: DE 41 13 120 C2
- [5]:: DE 10 2004 046 188 A1
- [6]:: DE 102 44 172 A1
- [7]:: US 6,650,926 B1
- [8]:: US 2008/0238424 A1
- [9]:: US 6,084,411

### Bezugszeichenliste

| | |
|---|---|
| 1 | MRI-System |
| 2 | Computer |
| 2a | Interface |
| 2b | Disc storage |
| 3 | Transmitter |
| 4 | Averager |
| 5a | Gx Gradientenstromversorgung |
| 5b | Gy Gradientenstromversorgung |
| 5c | Gz Gradientenstromversorgung |
| 6a | Gx Gradientenspule |
| 6b | Gy Gradientenspule |
| 6c | Gz Gradientenspule |
| 7 | HF Leistungsverstärker |
| 8 | Sendeantenne |
| 9 | Empfänger |
| 10 | Vorverstärker |
| 11 | Empfangsantenne |
| 12 | Magnet |
| 13 a-c | Schematische Darstellung eines Entkopplungselementes |
| 14 | Leiterschleife des Einzelantennenmodules |
| 15 | Tuning Netzwerk |
| 16 | Matching Netzwerk |
| 17 | Detuning Netzwerk |
| 18 | Tuning-Kapazität |
| 19 | Matching-Kapazität |
| 20 | Diode |
| 21 | Balun / Mantelwellensperre |
| 22 | HF-Kabel |
| 23 | Gehäuse des Einzelantennenelementes |
| 24 | Trägerkörper |
| 25 a-b | Band zur Befestigung des Trägerkörpers am Objekt |
| 26 a-b | Klettverschluss zur Befestigung des Trägerkörpers am Objekt |
| 27 | Einzelantennenmodul |
| 28 | Stift des Trägerkörpers zur Positionierung des Einzelantennenmodules gegenüber dem Trägerkörper |
| 29 | Führungsloch im Einzelantennenmodul zur Aufnahme des Stiftes 28 |
| 30 | Rändelschraube |
| 31 | Loch im Einzelantennenmodul für Rändelschraube |
| 32 | Gewinde im Trägerkörper für Rändelschraube |
| 33 | Markierung auf dem Trägerkörper, welche die Position des Einzelantennenmoduls anzeigt. |
| 34 | Kontaktstift am Einzelantennenmodul |
| 35 | Kontakthülse für Kontaktstift |
| 36 | Entkopplungskapazität |
| 37 | Leiterbahn |
| 38 | Codierwiderstand |
| 39 | Kontakthülse für Kontaktstift für Codierwiderstand |
| 40 | Kontaktstift für Codierwiderstand |
| 41 | Leiterschleife in Schmetterlingsform |
| 42 | Transformator |

## Patentansprüche

1. Antennenanordnung zur Verwendung in einem Magnetresonanzgerät, die als phasengesteuertes Array aufgebaut ist und einen Trägerkörper (24) aus einem stabilen Material und mindestens zwei Einzelantennen (8, 11; 11a, 11 b, 11 c) umfasst, welche jeweils mindestens eine Leiterschleife (14), ein Tuning-Netzwerk (15) und ein Matching-Netzwerk (16) aufweisen, wobei das Tuning-Netzwerk (15) mindestens eine Tuning-Kapazität (18) und das Matching-Netzwerk (16) mindestens eine Matching-Kapazität (19) enthält, und die Einzelantennen (8, 11; 11 a, 11b, 11 c) jeweils in separaten Modulen (27) zusammengefasst sind, die auf dem Trägerkörper (24) positioniert, befestigt und zerstörungsfrei von dort wieder entfernt werden können,
**dadurch gekennzeichnet,**
**dass** die Einzelantennen (8, 11; 11 a, 11 b, 11c) durch Entkopplungselemente (13a, 13b, 13c) miteinander verbunden sind, um die Einzelantennen (8, 11; 11a, 11b, 11c) untereinander elektromagnetisch zu entkoppeln,
und **dass** die Entkopplungselemente (13a, 13b, 13c) am Trägerkörper (24) befestigt sind und von diesem nicht zerstörungsfrei entfernt werden können.

2. Antennenanordnung nach Anspruch 1, **dadurch gekennzeichnet,**
**dass** die Entkopplungselemente (13a, 13b, 13c) auf dem Trägerkörper (24) als Leiterbahnen (41) in Schmetterlingsgeometrie ausgeführt sind.

3. Antennenanordnung nach Anspruch 1, **dadurch gekennzeichnet,**
**dass** die Entkopplungselemente (13a, 13b, 13c) auf dem Trägerkörper (24) als Kapazitäten (36) ausgeführt sind.

4. Antennenanordnung nach Anspruch 1, **dadurch gekennzeichnet,**
**dass** die Entkopplungselemente (13a, 13b, 13c) auf dem Trägerkörper (24) als induktive Entkopplungsspulen ausgeführt sind.

5. Antennenanordnung nach Anspruch 1, **dadurch gekennzeichnet, dass** die Entkopplungselemente (13a, 13b, 13c) auf dem Trägerkörper (24) als Transformatoren (42) ausgeführt sind.

6. Antennenanordnung nach einem der vorhergehenden Ansprüche,
**dadurch gekennzeichnet, dass** die Anordnung ein Detuning-Netzwerk (17) aufweist, welches mindestens eine Diode (20) enthält.

7. Antennenanordnung nach einem der vorhergehenden Ansprüche,
**dadurch gekennzeichnet, dass** der Trägerkörper (24) zusätzlich noch mit einem Codierelement (38 39) ausgerüstet ist, welches die Geometrie des Trägerkörpers (24) und die Einzelantennen-Position auf dem Trägerkörper (24) codiert und anhand dessen die Spannungsversorgung von Kapazitätsdioden in den Einzelantennen (8, 11; 11a, 11b, 11c) geregelt, werden kann.

8. Set von Trägerkörpern (24) unterschiedlicher Geometrie zur modularen Anordnung identischer Antennenmodule zum Aufbau einer Antennenanordnung nach einem der vorhergehenden Ansprüche, **dadurch gekennzeichnet, dass** unterschiedliche Trägerkörper (24) mit fix daran befestigten Entkopplungselementen (13a, 13b, 13c) vorgesehen sind, wobei die Einzclantennen in modularer Art und Weise auf den einzelnen Trägerkörpern (24) befestigt werden können und die auf den Trägerkörpern (24) befestigten Entkopplungselemente (13a, 13b, 13c) so gewählt sind, dass die Entkopplung der Einzclantennen (8, 11; 11a, 11b, 11c) untereinander maximal ist.

9. Set nach Anspruch 8, **dadurch gekennzeichnet, dass** die Trägerkörper (24) als Zylinder in unterschiedlichen Größen ausgeführt sind.

## Claims

1. Antenna configuration for use in a magnetic resonance apparatus, which is designed as a phase-controlled array and comprises a support body (24) of a stable material and at least two individual antennas (8, 11; 11a, 11b, 11c), each comprising at least one conductor loop (14), one tuning network (15) and one matching network (16), wherein the tuning network (15) contains at least one tuning capacitance (18) and the matching network (16) contains at least one matching capacitance (19), and the individual antennas (8, 11; 11a, 11b, 11c) are each combined into separate modules (27) which can be positioned on and mounted to the support body (24) and can be removed therefrom in a non-destructive fashion,
**characterized in that**
the individual antennas (8, 11; 11a, 11b, 11c) are connected to each other through decoupling elements (13a, 13b, 13c) for electromagnetically decoupling the individual antennas (8, 11; 11a, 11b, 11c) from each other,
and the decoupling elements (13a, 13b, 13c) are mounted to the support body (24) and cannot be removed therefrom in a non-destructive fashion.

2. Antenna configuration according to claim 1, **characterized in that** the decoupling elements (13a, 13b, 13c) on the support body (24) are designed in the form of conductor paths (41) having a butterfly geometry.

3. Antenna configuration according to claim 1, **characterized in that** the decoupling elements (13a, 13b, 13c) on the support body (24) are designed in the form of capacitances (36).

4. Antenna configuration according to claim 1, **characterized in that** the decoupling elements (13a, 13b, 13c) on the support body (24) are designed in the form of inductive decoupling coils.

5. Antenna configuration according to claim 1, **characterized in that** the decoupling elements (13a, 13b, 13c) on the support body (24) are designed in the form of transformers (42).

6. Antenna configuration according to any one of the preceding claims, **characterized in that** the configuration comprises a detuning network (17) which contains at least one diode (20).

7. Antenna configuration according to any one of the preceding claims, **characterized in that** the support body (24) is additionally provided with an encoding element (38, 39) which encodes the geometry of the support body (24) and the position of the individual antennas on the support body (24), on the basis of which the voltage supply of capacitance diodes in the individual antennas (8, 11; 11a, 11b, 11c) can be regulated.

8. Set of support bodies (24) of different geometry for modular arrangement of identical antenna modules for configuration of an antenna configuration according to any one of the preceding claims, **characterized in that** different support bodes (24) are provided to which decoupling elements (13a, 13b, 13c) are fixed, wherein the individual antennas can be mounted in a modular fashion to the individual support bodies (24) and the decoupling elements (13a, 13b, 13c) mounted to the support bodies (24) are selected in such a fashion that decoupling of the individual antennas (8, 11; 11a, 11b, 11c) from each other is maximized.

9. Set according to claim 8, **characterized in that** the support bodies (24) are designed in the form of cylinders having different sizes.

## Revendications

1. Agencement d'antenne destiné à être utilisé dans un appareil à résonance magnétique, qui est réalisé sous la forme d'un réseau à commande de phase et comprend un corps porteur (24) dans un matériau stable et au moins deux antennes individuelles (8, 11 ; 11a, 11b, 11c), lesquelles présentent chaque fois au moins une boucle conductrice (14), un réseau d'accord (15) et un réseau d'adaptation (16), le réseau d'accord (15) contenant au moins une capacité d'accord (18) et le réseau d'adaptation (16) au moins une capacité d'adaptation (19), et les antennes individuelles (8, 11 ; 11a, 11b, 11c) étant réunies chaque fois dans des modules (27) séparés qui sont positionnés et fixés sur le corps porteur (24) et peuvent être démontés de celui-ci de manière non destructive,
**caractérisé en ce**
**que** les antennes individuelles (8, 11 ; 11a, 11b, 11c) sont reliées entre elles par des éléments de découplage (13a, 13b, 13c) pour découpler électromagnétiquement les antennes individuelles (8, 11 ; 11a, 11b, 11c) les unes des autres,
et **que** les éléments de découplage (13a, 13b, 13c) sont fixés sur le corps porteur (24) et ne peuvent pas être démontés de celui-ci de manière non destructive.

2. Agencement d'antenne selon la revendication 1, **caractérisé en ce que** les éléments de découplage (13a, 13b, 13c) prévus sur le corps porteur (24) sont réalisés sous la forme de pistes conductrices (41) présentant une géométrie de type papillon.

3. Agencement d'antenne selon la revendication 1, **caractérisé en ce que** les éléments de découplage (13a, 13b, 13c) prévus sur le corps porteur (24) sont réalisés sous la forme de capacités (36).

4. Agencement d'antenne selon la revendication 1, **caractérisé en ce que** les éléments de découplage (13a, 13b, 13c) prévus sur le corps porteur (24) sont réalisés sous la forme de bobines de découplage inductif.

5. Agencement d'antenne selon la revendication 1, **caractérisé en ce que** les éléments de découplage (13a, 13b, 13c) prévus sur le corps porteur (24) sont réalisés sous la forme de transformateurs (42).

6. Agencement d'antenne selon une des revendications précédentes, **caractérisé en ce que** l'agencement présente un réseau de désaccord (17) qui contient au moins une diode (20).

7. Agencement d'antenne selon une des revendications précédentes, **caractérisé en ce que** le corps porteur (24) est également équipé d'un élément de codage (38, 39) qui code la géométrie du corps porteur (24) et la position des antennes individuelles sur le corps porteur (24), et à l'aide duquel l'alimentation en tension de diodes de capacité dans les antennes individuelles (8, 11 ; 11a, 11b, 11c) peut être réglée.

8. Ensemble de corps porteurs (24) de géométrie différente pour l'agencement modulaire de modules d'antenne identiques en vue de construire un agencement d'antenne selon une des revendications précédentes, **caractérisé en ce que** différents corps porteurs (24) équipés d'éléments de découplage (13a, 13b, 13c) fixes sont prévus, les antennes individuelles pouvant être fixées d'une manière modulaire sur les différents corps porteurs (24) et les éléments de découplage (13a, 13b, 13c) fixés sur les corps porteurs (24) étant choisis de façon que le découplage des antennes individuelles (8, 11 ; 11a, 11b, 11c) entre elles soit maximum.

9. Ensemble selon la revendication 8, **caractérisé en ce que** les corps porteurs (24) sont réalisés sous la forme de cylindres de tailles différentes.
